# EUROPÄISCHE PATENTSCHRIFT

(11) **EP 3 034 527 B1**
(45) Veröffentlichungstag und Bekanntmachung des Hinweises auf die Patenterteilung: **31.05.2017**
(21) Anmeldenummer: 14199279.2
(22) Anmeldetag: 19.12.2014
(51) Int. Cl.: C08F 255/02, C09D 123/04, C08F 226/06, H01L 31/00, C09D 4/06

(54) **Covernetzersysteme für Verkapselungsfolien umfassend Bis-(alkenylamid)-Verbindungen**
Cover net systems for encapsulation films comprising bis-(alkenylamide) compounds
Systèmes d'agent de co-réticulation pour feuilles d'encapsulage comprenant des combinaisons bis-(alcényle amide).

(43) Veröffentlichungstag der Anmeldung: 22.06.2016
(73) Patentinhaber: Evonik Degussa GmbH, 45128 Essen (DE)
(72) Erfinder: Ulbricht, Daniel, 64295 Darmstadt (DE); Hein, Marcel, 63843 Niedernberg (DE); Kleff, Frank, 63486 Bruchköbel-Oberissigheim (DE); Schauhoff, Stephanie, 63225 Langen (DE); Ohlemacher, Jürgen, 61118 Bad Vilbel (DE)

(56) Entgegenhaltungen:
- EP-A1- 1 164 167
- EP-A1- 2 581 409
- EP-A2- 0 227 470
- WO-A1-2014/129573
- CN-A- 103 804 774
- CN-B- 102 504 715

## Beschreibung

Die vorliegende Erfindung betrifft eine erste Zusammensetzung **(A)** umfassend (i) mindestens eine Verbindung **(I)** ausgewählt aus der Gruppe bestehend aus Triallylisocyanurat, Triallylcyanurat, wobei die Verbindung **(I)** bevorzugt Triallylisocyanurat ist; und (ii) mindestens eine Bis-(alkenylamid)-Verbindung. Daneben betrifft die vorliegende Erfindung auch eine zweite Zusammensetzung **(B)** umfassend die erste Zusammensetzung **(A)** und mindestens ein Polyolefincopolymer. Schließlich betrifft die vorliegende Erfindung die Verwendung der Zusammensetzung **(B)** zur Herstellung einer Folie zur Verkapselung einer elektronischen Vorrichtung, insbesondere einer Solarzelle.

### Hintergrund der Erfindung

Photovoltaikmodule (Photovoltaik = "PV") bestehen üblicherweise aus einer Lage symmetrisch angeordneter Siliziumzellen, welche in zwei Lagen einer Schutzfolie eingeschweißt werden. Diese Schutzfolie ist selbst wiederum durch ein "*backsheet*" auf ihrer Rück- und ein "*frontsheet*" auf ihrer Vorderseite stabilisiert. "*Backsheet*" und "*frontsheet*" können sowohl geeignete Kunststofffolien sein als auch aus Glas bestehen. Die Funktion des Verkapselungsmaterials besteht im Wesentlichen darin, das PV-Modul vor Witterungseinflüssen und mechanischer Belastung zu schützen, weshalb die mechanische Stabilität des jeweiligen Verkapselungsmaterials eine wichtige Eigenschaft darstellt. Daneben weisen gute Verkapselungsmaterialien eine schnelle Aushärtungsgeschwindigkeit, einen hohen Gelgehalt, eine hohe Transmission, eine geringe Neigung zu temperatur- und wärmeinduzierter Verfärbung sowie eine hohe Adhäsion (also eine geringe Neigung zur UV-induzierten Delaminierung) auf.

Die im Stand der Technik (zum Beispiel WO 2008/036708 A2) zu diesem Zweck beschriebenen Verkapselungsmaterialien beruhen typischerweise auf Materialien wie Silikonharzen, Polyvinylbutyralharzen, Ionomeren, Polyolefinfolien oder Ethylen-Vinylacetat-Copolymeren ("EVA"). Verfahren zur Herstellung solcher Verkapselungsfolien sind dem Fachmann geläufig (EP 1 164 167 A1). In diesen Verfahren werden die Vernetzer zusammen mit einem Polyolefincopolymer (und eventuell weiteren Additiven) z. B. in einem Extruder homogen vermischt und dann zu einer Folie extrudiert. Das in der EP 1 164 167 A1 beschriebene Verfahren betrifft Verkapselungsfolien auf Basis von EVA, ist aber auch auf Folien aus anderen, zum Beispiel den vorgenannten, Materialien anwendbar. EP 0 227 470 offenbart einen transparenten Film, der hauptsächlich mit Triallylisocyanurat vernetztes Ethylen-Vinylacetat Copolymer enthält.

Die Verkapselung der Siliziumzellen erfolgt typischerweise in einem Vakuumlaminierofen (EP 2 457 728 A1). Dazu wird der Schichtaufbau des PV-Moduls vorbereitet und in einem Laminierofen (bestehend aus zwei durch eine Membran getrennten Kammern) zunächst langsam aufgeheizt. Dadurch erweicht das Polyolefin-Copolymer (zum Beispiel EVA). Gleichzeitig wird der Ofen evakuiert, um die Luft zwischen den Schichten zu entfernen. Dieser Schritt ist der kritischste und dauert zwischen 4 bis 6 Minuten. Im Anschluss daran wird das Vakuum über die zweite Kammer gebrochen, und über Anlegen eines Drucks werden die Schichten des Moduls miteinander verschweißt. Gleichzeitig wird bis zur Vernetzungstemperatur weiter aufgeheizt, wobei in diesem letzten Schritt dann die Vernetzung der Folie stattfindet.

Gerade EVA wird standardmäßig bei der Herstellung von Verkapselungsfolien für Solarmodule eingesetzt. Allerdings weist es auch einen geringeren spezifischen elektrischen Durchgangswiderstand p als z. B. Polyolefonfolien auf. Dies macht den Einsatz von EVA-Folien als Verkapselungsmaterial unattraktiver, da gerade Verkapselungsmaterialien mit hohem spezifischem elektrischem Durchgangswiderstand p gewünscht sind.

Bei PV-Modulen stellt nämlich der sogenannte "PID"-Effekt (PID = "*potential induced degradation*") derzeit ein großes Qualitätsproblem dar. Unter dem Begriff PID versteht man eine spannungsbedingte Leistungsdegradation, hervorgerufen durch sogenannte "Leckströme" innerhalb des PV-Moduls.

Ursache für die schädlichen Leckströme ist neben dem Aufbau der Solarzelle die Spannungslage der einzelnen PV-Module gegenüber dem Erdpotential - bei den meisten ungeerdeten PV-Systemen sind die PV-Module einer positiven oder negativen Spannung ausgesetzt. PID tritt meistens bei einer negativen Spannung gegenüber Erdpotential auf und wird durch hohe Systemspannungen, hohe Temperaturen und hohe Luftfeuchtigkeit beschleunigt. In der Folge wandern Natriumionen aus dem Deckglas des PV-Moduls an die Grenzfläche der Solarzelle und verursachen dort Schäden ("*shunt*"), die zu Leistungsverlusten und sogar zum Totalverlust des PV-Moduls führen können.

Das Risiko des Eintretens eines PID-Effektes kann durch die Erhöhung des spezifischen elektrischen Durchgangswiderstands p der Verkapselungsfolien deutlich reduziert werden.

Der spezifische elektrische Durchgangswiderstand p oder auch Resistivität ("*volume resistivity*", im Folgenden auch abgekürzt als "*VR*") ist eine temperaturabhängige Materialkonstante. Er wird zur Berechnung des elektrischen Widerstands eines homogenen elektrischen Leiters genutzt. Der spezifische elektrische Durchgangswiderstand wird erfindungsgemäß mittels ASTM-D257 bestimmt.

Je höher der spezifische elektrische Durchgangswiderstand p eines Materials ist, desto geringer ist die Anfälligkeit von Photovoltaikmodulen gegenüber dem PID-Effekt. Eine wesentliche, positive Auswirkung bei der Steigerung des spezifischen elektrischen Durchgangswiderstands p von Verkapselungsfolien ist daher die Erhöhung der Lebensdauer und Effizienz von PV-Modulen.

Im Stand der Technik wird das Problem des PID-Effekts im Zusammenhang mit Verkapselungsfolien für PV-Module in der CN 103525321 A diskutiert. Diese Schrift beschreibt eine EVA-basierte Folie zur Verkapselung von Solarzellen, welche als Co-Vernetzer Triallylisocyanurat ("TAIC") und Trimethylolpropantrimethacrylat ("TMPTMA") sowie als weitere Additive bevorzugt ein Polyolefinionomer und ein Polysiloxan zur Hydrophobisierung enthält. Diese Folie weist einen verminderten PID-Effekt auf. Nachteilig an ihr ist allerdings, dass Polyolefinionomere relativ teuer sind. Außerdem wirken sich Polysiloxane negativ auf die Haftungseigenschaften aus. Zudem werden in den Beispielen keine spezifischen Angaben darüber gemacht, mit welchen Konzentrationen welche Verbesserungen erreicht werden können.

Eine Vernetzerkombination aus TAIC und TMPTMA beschreibt auch die JP 2007-281135 A. Das TMPTMA bewirkt hierbei eine Beschleunigung der Vernetzungsreaktion und führt damit zu einer erhöhten Produktivität.

Die JP 2012-067174 A und die JP 2012-087260 A beschreiben eine auf EVA bzw. einem Polyolefin basierende Verkapselungsfolie für Solarzellen, die neben TAIC zum Beispiel Ethylenglykoldimethacrylat, Neopentylglykoldimethacrylat, 1,6-Hexandioldimethacrylat als Vernetzer aufweist. Diese Covernetzer verlangsamen die Vernetzungsreaktion am Anfang etwas und erhöhen dadurch das Verarbeitungszeitfenster.

Die JP 2009-135200 A beschreibt ebenfalls Vernetzer umfassend TAIC und verschiedene (Meth)acrylatderivate polyfunktioneller Alkohole, wobei in diesem Fall eine verbesserte Hitzebeständigkeit verbunden mit einer geringeren Tendenz zur Delamination der EVA-basierten Verkapselung beschrieben wird.

Die JP 2007-281135 A und die JP 2007-305634 A beschreiben Vernetzerkombinationen aus TAIC und Trimethylolpropantriacrylat ("TMPTA") zur Verwendung bei der Herstellung von mehrschichtigen co-extrudierten EVA-Verkapselungsfolien für Solarzellen.

Ähnliche Kombinationen von Vernetzern für Solarzellenverkapselungsfolien beschreiben z. B. die JP 2013-138094 A, JPH11-20094, JPH11-20095, JPH11-20096, JPH11-20097, JPH11-20098, JPH11-21541, CN 102391568 A, CN 102504715 A, CN 102863918 A, CN 102911612 A, CN 103045105 A, CN 103755876 A, CN 103804774 A, US 2011/0160383 A1, WO 2014/129573 A1.

Demnach besteht ein Bedürfnis hinsichtlich neuer Covernetzersysteme, insbesondere zur Herstellung von Verkapselungsfolien für Solarzellen, die im Vergleich zu Folien, die nach dem Stand der Technik vernetzt sind, zu einem deutlich erhöhten elektrischen Durchgangswiderstand führen, um so beim Einsatz in Photovoltaikmodulen zu einer Verringerung des PID-Risikos führt.

Aufgabe der vorliegenden Erfindung war es deshalb, neue Zusammensetzungen zur Verfügung zu stellen, die zur Herstellung von Folien mit möglichst hohem spezifischen elektrischen Durchgangswiderstands p verwendet werden können und sich somit besonders zur Verkapselung von elektronischen Vorrichtungen wie zum Beispiel Solarzellen eignen. Diese Zusammensetzungen sollten außerdem in den etablierten Prozessen einsetzbar sein und die Kosten der Folien nicht wesentlich erhöhen. Insbesondere sollten Sie nicht die Nachteile aufweisen, die bei den Covernetzersystemen des Standes der Technik, und hier insbesondere bei jenen in der CN 103525321 A genannten Zusammensetzungen, beobachtet werden.

Es wurde nun überraschend gefunden, dass mit Hilfe bestimmter Zusammensetzungen eine Verkapselungsfolie für Solarzellen erhalten werden kann, die diese Anforderungen erfüllt. Die hier gefundenen Zusammensetzungen erhöhen den Volumenwiderstand erheblich bei vergleichsweise kleinen Einsatzmengen, ohne andere Folieneigenschaften negativ zu beeinflussen. Die Folien haben eine exzellente Verarbeitbarkeit, eine hohe Transparenz und exzellente UV- und Wärmealterungseigenschaften.

### Detaillierte Beschreibung der Erfindung

Die Covernetzersysteme gemäß der vorliegenden Erfindung können überraschend zur Herstellung von Folien zur Verkapselung von elektronischen Vorrichtungen wie zum Beispiel Solarzellen mit einem hohen spezifischen Durchgangswiderstand verwendet werden.

Das erfindungsgemäße Covernetzersystem ist demnach eine Zusammensetzung **(A)** umfassend (i) mindestens eine Verbindung **(I)** ausgewählt aus der Gruppe bestehend aus Triallylisocyanurat, Triallylcyanurat, wobei Triallylisocyanurat als Verbindung **(I)** besonders bevorzugt ist; und
(ii) mindestens eine Verbindung **(II)**, wobei die Verbindung **(II)** allgemein durch die Strukturformel: 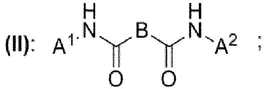 definiert ist:
wobei
A¹, A² unabhängig voneinander jeweils ausgewählt sind aus der Gruppe bestehend aus
unverzweigte oder verzweigte Alkenylgruppe mit 3 bis 18 Kohlenstoffatomen, welche mindestens eine terminale Doppelbindung aufweist,
eine Gruppe der chemischen Struktur **(III)** mit 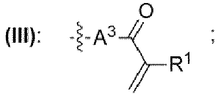 wobei
   R¹ = Wasserstoff oder Methyl ist;
   A³ eine unverzweigte oder verzweigte Alkylengruppe mit 1 bis 12 Kohlenstoffatomen ist;
B ausgewählt aus der Gruppe bestehend aus -NR²-, der chemischen Struktur -(CH₂)ₚ-NR³-(CH₂)_{q}-, und der chemischen Struktur **(IV)** mit 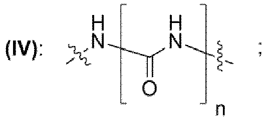 ist,
   wobei R², R³ unabhängig voneinander jeweils ausgewählt sind aus der Gruppe bestehend aus Wasserstoff, Alkylgruppe mit 1 bis 20 Kohlenstoffatomen, unverzweigte oder verzweigte Alkenylgruppe mit 3 bis 18 Kohlenstoffatomen, welche mindestens eine terminale Doppelbindung aufweist,
   eine Gruppe der chemischen Struktur **(V)** mit 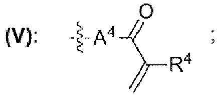 wobei
      R⁴ = Wasserstoff oder Methyl ist;
      A⁴ eine unverzweigte oder verzweigte Alkylengruppe mit 1 bis 12 Kohlenstoffatomen ist;
und wobei n, p, q unabhängig voneinander jeweils eine ganze Zahl im Bereich 1 bis 5 ist;
und wobei mindestens eine von der Zusammensetzung **(A)** umfasste Verbindung **(II)** in einem Anteil von mindestens 1 Gew.-%, bezogen auf das Gesamtgewicht aller von der Zusammensetzung **(A)** umfassten Verbindungen **(I)**, vorliegt.

In einer bevorzugten Ausführungsform liegt mindestens eine von der Zusammensetzung **(A)** umfasste Verbindung **(II)** in einem Anteil von mindestens 1 Gew.-% bis 50 Gew.-%, bevorzugt 1.7 Gew.-% bis 25 Gew.-%, bevorzugter 2.1 Gew.-% bis 11.1 Gew.-%, noch bevorugter 2.2 Gew.-% bis 6.4 Gew.-%, noch mehr bevorzugter 3.1 Gew.-% bis 6.4 Gew.-%, am bevorzugtestens 4.4 Gew.-% bis 5.3 Gew.-%, bezogen auf das Gesamtgewicht aller von der Zusammensetzung **(A)** umfassten Verbindungen **(I)**, vor.

In einer bevorzugten Ausführungsform sind in der Zusammensetzung **(A)**
A¹, A² unabhängig voneinander jeweils ausgewählt aus der Gruppe bestehend aus Allylgruppe, Methallylgruppe, einer Gruppe der chemischen Struktur **(III)** mit 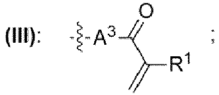 wobei
R¹ = Wasserstoff oder Methyl ist;
A³ eine unverzweigte oder verzweigte Alkylengruppe mit 1 bis 6 Kohlenstoffatomen ist;
B ausgewählt aus der Gruppe bestehend aus -NR²-, -CH₂-NH-CH₂-, und der chemischen Struktur **(IV)** mit 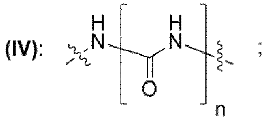 wobei R² ausgewählt aus der Gruppe bestehend aus Wasserstoff, Alkylgruppe mit 1 bis 20 Kohlenstoffatomen, Allylgruppe, Methallylgruppe,
eine Gruppe der chemischen Struktur **(V)** mit 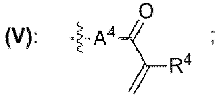 ist, wobei
R⁴ = Wasserstoff oder Methyl ist;
A⁴ eine unverzweigte oder verzweigte Alkylengruppe mit 1 bis 6 Kohlenstoffatomen ist;
und wobei n eine ganze Zahl im Bereich 1 bis 3 ist.

Am bevorzugtesten ist in der Zusammensetzung **(A)** die Verbindung **(II)** ausgewählt aus der Gruppe bestehend aus den chemischen Strukturen **(VI)**, **(VII)**, **(VIII)**, **(IX)**, **(X)** mit 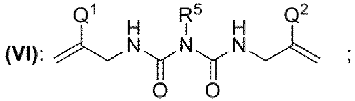 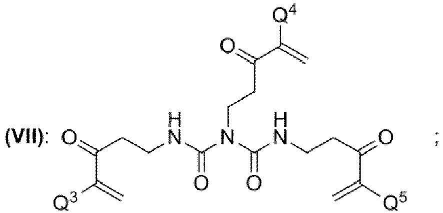 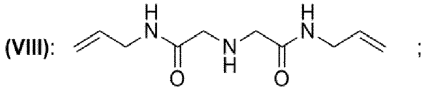 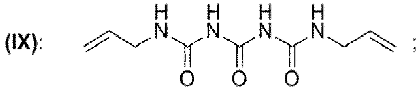 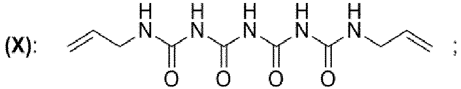
wobei R⁵ ausgewählt aus der Gruppe bestehend aus
Wasserstoff, Alkylgruppe mit 1 bis 20 Kohlenstoffatomen, Allylgruppe, Methallylgruppe ist;
und wobei Q¹, Q², Q³, Q⁴, Q⁵ unabhängig voneinander jeweils Wasserstoff oder Methyl ist.
Am bevorzugtesten ist in der Zusammensetzung **(A)** die Verbindung **(II)** ausgewählt aus Triallylbiuret, *N*-Propyl-diallylbiuret, Imino-di-(essigsäure-*N*-allylamid).

Eine Verbindung der chemischen Struktur **(II)** wird im Sinne der Erfindung auch als "Bis-(alkenylamid)-Verbindung" bezeichnet.

Der Ausdruck "mindestens eine von der Zusammensetzung **(A)** umfasste Verbindung **(II)** liegt in einem Anteil von mindestens 1 Gew.-%, bezogen auf das Gesamtgewicht aller von der Zusammensetzung **(A)** umfassten Verbindungen **(I)**, vor" bedeutet, dass in der Zusammensetzung **(A)** mindestens eine Verbindung, die unter die allgemeine Strukturformel **(II)** fällt, in einer Menge von mindestens 1 Gew.-%, bezogen auf das Gesamtgewicht aller von Zusammensetzung **(A)** umfassten Verbindungen **(I)**, vorliegt.

Beispielsweise bedeutet dies, dass in der erfindungsgemäßen Ausführungsform, in welcher die Zusammensetzung **(A)** als Verbindung **(I)** Triallylisocyanurat und als Verbindung **(II)** Triallylbiuret umfasst, das Triallylbiuret in einem Anteil von mindestens 1.0 Gew.-%, bezogen auf das Gewicht des Triallylisocyanurats, vorliegt. In einer noch bevorzugteren Ausführungsform beträgt der Anteil von Triallylbiuret, bezogen auf das Gewicht des Triallylisocyanurats, dann 2.1 bis 25.0 Gew.-%, besonders bevorzugt 3.1 Gew.-% bis 11.1 Gew.-%, am bevorzugtesten 5.3 Gew.-% bis 6.4 Gew.-%. Triallylbiuret ist eine Verbindung der Formel **(VI)**, in welcher Q¹ = Q² = H und R⁵ = Allyl. Beispielsweise bedeutet dies auch, dass in der erfindungsgemäßen Ausführungsform, in welcher die Zusammensetzung **(A)** als Verbindung **(I)** Triallylisocyanurat und als Verbindung **(II)** *N*-Propyl-diallylbiuret umfasst, das *N*-Propyl-diallylbiuret in einem Anteil von mindestens 1.0 Gew.-%, bezogen auf das Gewicht des Triallylisocyanurats, vorliegt. In einer noch bevorzugteren Ausführungsform beträgt der Anteil von *N*-Propyl-diallylbiuret, bezogen auf das Gewicht des Triallylisocyanurats, dann 1.1 bis 5 Gew.-%, besonders bevorzugt 1.5 Gew.-% bis 3.0 Gew.-%, am bevorzugtesten 1.7 Gew.-%. *N*-Propyl-diallylbiuret ist eine Verbindung der Formel **(VI)**, in welcher Q¹ = Q² = H und R⁵ = n-Propyl.

Beispielsweise bedeutet dies auch, dass in der erfindungsgemäßen Ausführungsform, in welcher die Zusammensetzung **(A)** als Verbindung **(I)** Triallylisocyanurat und als Verbindung **(II)** Imino-di-(essigsäure-*N*-allylamid) umfasst, das Imino-di-(essigsäure-*N*-allylamid) in einem Anteil von mindestens 1.0 Gew.-%, bezogen auf das Gewicht des Triallylisocyanurats, vorliegt. In einer noch bevorzugteren Ausführungsform beträgt der Anteil von Imino-di-(essigsäure-*N*-allylamid), bezogen auf das Gewicht des Triallylisocyanurats, dann 1.1 bis 10.0 Gew.-%, besonders bevorzugt 2.2 Gew.-% - 8 Gew.-%, am bevorzugtesten 4.4 Gew-%. Imino-di-(essigsäure-*N*-allylamid) ist die Verbindung der Formel **(VIII)**.

Beispielsweise bedeutet dies auch, dass in der erfindungsgemäßen Ausführungsform, in welcher die Zusammensetzung **(A)** als Verbindung **(I)** Triallylcyanurat und als Verbindung **(II)** Triallylbiuret umfasst, das Triallylbiuret in einem Anteil von mindestens 1.0 Gew.-%, bezogen auf das Gewicht des Triallylcyanurats, vorliegt. In einer noch bevorzugteren Ausführungsform beträgt der Anteil von Triallylbiuret, bezogen auf das Gewicht des Triallylcyanurats, dann 2.1 bis 25 Gew.-%, besonders bevorzugt 3.1 Gew.-% bis 11.1 Gew.-%, am bevorzugtesten 5.3 Gew.-% bis 6.4 Gew.-%.

Die Gruppen "Allylgruppe" und "Methallylgruppe" haben jeweils die folgende chemische Struktur:

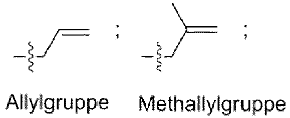

Im Sinne der Erfindung ist eine "unverzweigte oder verzweigte Alkenylgruppe, welche mindestens eine terminale Doppelbindung aufweist" eine einwertige unverzweigte oder verzweigte Kohlenwasserstoffgruppe, die mindestens eine terminale Doppelbindung aufweist.

Bevorzugt weist eine "unverzweigte oder verzweigte Alkenylgruppe mit 3 bis 18 Kohlenstoffatomen, welche mindestens eine terminale Doppelbindung aufweist" im Sinne der Erfindung eine chemische Struktur 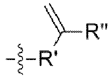
auf, wobei R' eine unverzweigte oder verzweigte Alkylengruppe mit x Kohlenstoffatomen ist und R" unabhängig davon Wasserstoff oder eine unverzweigte oder eine verzweigte Alkylgruppe mit y Kohlenstoffatomen ist, wobei x und y ganzzahlig sind;
und wobei x für R" = H im Bereich 1 bis 16 liegt (wenn x = 1, dann handelt es sich bei R' um Methylen); und
wobei x für den Fall, dass R" = unverzweigte oder verzweigte Alkylgruppe, im Bereich 1 bis 15 liegt und y dann im Bereich 1 bis (16 - x) liegt, wobei die Summe aus x + y dann den Wert 16 nicht übersteigen darf.

Insbesondere ist dann R" = H oder Methyl und R' ist eine unverzweigte oder verzweigte Alkylengruppe mit 1 bis 15 Kohlenstoffatomen. Bevorzugt ist R" = H oder Methyl und R' ist eine unverzweigte Alkylengruppe mit 1 bis 10 Kohlenstoffatomen. Bevorzugter ist R' = Methylen und R" = H oder Methyl.

Eine "Alkylengruppe" ist im Sinne der Erfindung ein zweiwertiger gesättigter Kohlenwasserstoffrest.

Eine unverzweigte oder verzweigte Alkylengruppe mit 1 bis 6 Kohlenstoffatomen ist insbesondere ausgewählt aus Methylen, Ethylen, *n*-Propylen, *n*-Butylen, *n*-Pentylen, *n*-Hexylen. "*n*-Hexylen" ist gleichbedeutend mit "Hexamethylen".

Um die Homogenität der Folie und die Wirksamkeit der Folie zu gewährleisten, ist es wesentlich, dass mindestens eine von der Zusammensetzung **(A)** umfasste Verbindung **(II)** in einem Anteil von mindestens 1 Gew.-%, bezogen auf das Gesamtgewicht aller von der Zusammensetzung **(A)** umfassten Verbindungen **(I)**, vorliegt. Dies gewährleistet, dass der spezifische Widerstand der damit erhältlichen Folien gerade die für großtechnische Anwendungen notwendigen Werte erreicht und eine ausreichende Verbesserung gegenüber den Vernetzersystemen des Standes der Technik erreicht wird. Zusammensetzungen, in denen keine einzige Verbindung **(II)** in einer solch ausreichenden Menge vorliegt, tragen nicht in ausreichendem Masse zur Erhöhung des spezifischen Widerstandes bei.

Was den Anteil aller Verbindungen der chemischen Struktur **(II)** in der Zusammensetzung **(A)** angeht, so ist dieser nur durch die zuvor beschriebene Vorgabe bezüglich des Anteils mindestens einer von der Zusammensetzung **(A)** umfassten Verbindung **(II)** beschränkt. Vorzugsweise liegt das Gesamtgewicht aller von der Zusammensetzung **(A)** umfassten Verbindungen der chemischen Struktur **(II)** in der Zusammensetzung **(A)** bezogen auf das Gesamtgewicht aller von der Zusammensetzung **(A)** umfassten Verbindungen **(I)** bei mindestens 1 Gew.-%, insbesondere im Bereich 1.1 Gew.-% bis 50. Gew.-%, bevorzugt 2 Gew.-% bis 20.0 Gew.-%, bevorzugter 3 Gew.-% bis 10.0 Gew.-%.

Die vorliegenden Covernetzersysteme werden bevorzugt zur Herstellung von Folien zur Verkapselung von elektronischen Vorrichtungen, z. B. Solarzellen in PV-Modulen, verwendet.

Dabei werden die Covernetzersysteme typischerweise zusammen mit Polyolefincopolymeren eingesetzt.

Die vorliegende Erfindung betrifft demnach auch eine Zusammensetzung **(B)** umfassend mindestens ein Polyolefincopolymer und die erfindungsgemäße Zusammensetzung **(A)**.

Erfindungsgemäß einsetzbare Polyolefincopolymere sind dem Fachmann bekannt und etwa in der WO 2008/036708 A2 und der JP 2012-087260 beschrieben.

Insbesondere werden erfindungsgemäß als Polyolefincopolymere Ethylen/ α-Olefin-Interpolymere eingesetzt, wobei der Begriff "Interpolymer" bedeutet, dass das betreffende Polyolefincopolymer aus mindestens zwei verschiedenen Monomeren hergestellt wurde. Somit schließt der Begriff "Interpolymer" insbesondere Polyolefincopolymere aus genau zwei Monomereinheiten, aber auch Terpolymere (zum Beispiel Ethylen/Propylen/1-Octen, Ethylen/Propylen/Buten, Ethylen/Buten/1-Octen, Ethylen/Buten/Styrol) und Tetrapolymere ein.

Als Polyolefincopolymere kommen erfindungsgemäß insbesondere Ethylen/ α-Olefin-Copolymere, die bevorzugt neben Ethylen und dem α-Olefin keine weiteren Monomereinheiten aufweisen, in Frage, wobei im Sinne der Erfindung das "α-Olefin" bevorzugt ausgewählt ist aus der Gruppe bestehend aus Propen, 1-Buten, 4-Methyl-1-Penten, 1-Hexen, 1-Octen, 1-Decen, 1-Dodecen, 1-Tetradecen, 1-Hexadecen, 1-Octadecen, 3-Cyclohexyl-1-propen, Vinylcyclohexan, Acrylsäure, Methacrylsäure, Norbornen, Styrol, Methylstyrol, Vinylacetat.

Noch bevorzugter ist das erfindungsgemäße Polyolefincopolymer in der Zusammensetzung **(B)** ein Ethylen-Vinylacetat-Copolymer.

Werden als Polyolefincopolymere Ethylen/ α-Olefin-Interpolymere eingesetzt, so weisen diese insbesondere einen α-Olefin-Gehalt im Bereich 15 bis 50 Gew.-%, bezogen auf das Gesamtgewicht des Ethylen/ α-Olefin-Interpolymers, auf. Bevorzugt liegt der α-Olefin-Gehalt im Bereich 20 bis 45 Gew.-%, bevorzugter im Bereich 25 bis 40 Gew.-%, noch bevorzugter 26 bis 34 Gew.-%, am bevorzugtesten 28 bis 33 Gew.-%, jeweils bezogen auf das Gesamtgewicht des Ethylen/ α-Olefin-Interpolymers.

In der bevorzugten Ausführungsform, in welcher es sich bei dem Polyolefincopolymer um ein Ethylen-Vinylacetat-Copolymer handelt, weist das Ethylen-Vinylacetat-Copolymer insbesondere einen Vinylacetat-Gehalt im Bereich 15 bis 50 Gew.-%, bezogen auf das Gesamtgewicht des Ethylen-Vinylacetat-Copolymers, auf. Bevorzugt liegt der Vinylacetat-Gehalt dann im Bereich 20 bis 45 Gew.-%, bevorzugter im Bereich 25 bis 40 Gew.-%, noch bevorzugter 26 bis 34 Gew.-%, am bevorzugtesten 28 bis 33 Gew.-% jeweils bezogen auf das Gesamtgewicht des Ethylen-Vinylacetat-Copolymers.

Der α-Olefin-Gehalt, insbesondere im Falle des Ethylen/ Vinylacetat-Copolymer der Gehalt an Vinylacetat, wird dabei mit dem in ASTM D 5594:1998 ["*Bestimmung des Vinylacetatgehalts von Ethylenvinylacetat(EVA)-Copolymeren mit Hilfe der Fourier-Transformations-Infrarotspektroskopie*"] beschriebenen Verfahren bestimmt.

Der Anteil der von der Zusammensetzung **(B)** umfassten Zusammensetzung **(A)** ist dabei nicht besonders beschränkt. Der Anteil der Zusammensetzung **(A)** in der Zusammensetzung **(B)** liegt insbesondere im Bereich von 0.05 bis 10 Gew.-%, bevorzugt im Bereich von 0.1 bis 5 Gew.-%, bevorzugter im Bereich von 0.2 bis 3 Gew.-%, noch bevorzugter bei 0.3 bis 1.5 Gew.-%, besonders bevorzugt bei 0.5 Gew-%, jeweils bezogen auf die Masse aller von der Zusammensetzung **(B)** umfassten Polyolefincopolymere.

Die Zusammensetzung **(B)** eignet sich erfindungsgemäß zur Herstellung einer Verkapselungsfolie für elektronische Vorrichtungen, zum Beispiel Solarzellen. Sie wird dazu bei der Solarmodul-Lamination einer Vernetzungsreaktion unterzogen.

Zum Start der Vernetzungsreaktion ist es üblich, Initiatoren einzusetzen, also durch Wärme, Licht, Feuchtigkeit oder Elektronenstrahlen aktivierbare Radikalbildner.

In einer bevorzugten Ausführungsform der vorliegenden Erfindung umfasst die Zusammensetzung **(B)** deshalb auch einen Initiator ausgewählt aus der Gruppe bestehend aus peroxidischen Verbindungen, Azoverbindungen, Photoinitiatoren. Bevorzugter ist der Initiator ausgewählt aus der Gruppe bestehend aus peroxidischen Verbindungen, Azoverbindungen. Beispiele dafür sind in der "Encyclopedia of Chemical Technology 1992, 3rd Edition, Vol. 17, Seiten 27- 90" beschrieben.

Peroxidische Verbindungen sind insbesondere organische Peroxide, welche wiederum ausgewählt sind aus der Gruppe bestehend aus Dialkylperoxiden, Diperoxyketalen, Peroxycarbonsäureestern, Peroxycarbonaten.

Dialkylperoxide sind insbesondere ausgewählt aus der Gruppe bestehend aus Dicumylperoxid, Di-*tert*-butylperoxid, Di-*tert*-Hexylperoxid, *tert*-Butylcumylperoxid, *iso*-Propylcumyl-*tert*-butylperoxid, *tert*-Hexylcumylperoxid, 2,5-Dimethyl-2,5-di(*tert*-butylperoxy)-hexan, 2,5-Dimethyl-2,5-di(*tert*-amylperoxy)-hexan, 2,5-Dimethyl-2,5-di(*tert*-butylperoxy)-hex-3-in, 2,5-Dimethyl-2,5-di(*tert*-amylperoxy)-hex-3-in, α,α-Di[(*tert*-butylperoxy)-*iso*-propyl]-benzol, Di-*tert*-amylperoxid, 1,3,5-Tri-[(*tert*-butylperoxy)-isopropyl]-benzol, 1,3-Dimethyl-3-(*tert*-butylperoxy)-butanol, 1,3-dimethyl-3-(*tert*-amylperoxy)-butanol, *iso*-Propylcumylhydroperoxid.

Diperoxyketale sind insbesondere ausgewählt aus der Gruppe bestehend aus 1,1-Di(*tert*-butylperoxy)-3,3,5-trimethylcyclohexan, 1,1-Di(*tert*-amylperoxy)-cyclohexan, 1,1-Di(*tert*-butylperoxy)-cyclohexan, *n*-Butyl-4,4-di(*tert*-amylperoxy)-valerat, Ethyl-3,3-di(*tert*-butylperoxy)-butyrat, 2,2-Di(*tert*-butylperoxy)butan, 3,6,6,9,9-Pentamethyl-3-ethoxycarbonylmethyl-1,2,4,5-tetraoxacyclononan, 2,2-Di(*tert*-amylperoxy)-propan, *n*-Butyl-4,4-bis(*tert*-butylperoxy)-valerat.

Peroxycarbonsäureester sind insbesondere ausgewählt aus der Gruppe bestehend aus *tert*-Amylperoxyacetat, *tert*-Butylperoxy-3,5,5-trimethylhexanoat, *tert*-Amylperoxybenzoat, *tert*-Butylperoxyacetat, *tert*-Butylperoxybenzoat, *OO*-*tert*-Butylmonoperoxysuccinat, *OO*-*tert*-Amylmonoperoxysuccinat.

Peroxycarbonate sind insbesondere ausgewählt aus der Gruppe bestehend aus *tert*-Butylperoxy-2-ethylhexylcarbonat, *tert*-Butylperoxy-*iso*-propylcarbonat, *tert*-Amylperoxy-2-ethylhexyl-carbonat, *tert*-Amylperoxybenzoat. Ein bevorzugtes Peroxycarbonat ist *tert*-Butylperoxy-2-ethylhexylcarbonat ("TBPEHC").

Die Azoverbindung ist bevorzugt ausgewählt aus der Gruppe bestehend aus 2,2'-Azobis-(2-acetoxypropan), 1,1'-Azodi(hexahydrobenzonitril).

Besonders bevorzugt ist der Initiator ausgewählt aus der Gruppe bestehend aus 2,5-Dimethyl-2,5-di(*tert*-butylperoxy)-hexan, *tert*-Butylperoxy-2-ethylhexylcarbonat, *tert*-Butylperoxy-3,5,5-trimethylhexanoat, 1,1-Di(*tert*-butylperoxy)-3,5,5-trimethylcyclohexan, *tert*-Amylperoxy-2-ethylhexylcarbonat; am bevorzugtesten ist der Initiator *tert*-Butylperoxy-2-ethylhexylcarbonat ("TBPEHC").

Die Masse der peroxidischen Verbindung oder der Azoverbindung, bevorzugt der peroxidischen Verbindung, welche bezogen auf die Masse des Polyolefincopolymers eingesetzt wird, ist nicht besonders beschränkt. Die peroxidische Verbindung oder die Azoverbindung, bevorzugt die peroxidische Verbindung, wird insbesondere in einer Menge von 0.05 bis 10 Gew.-%, bevorzugt 0.1 bis 5 Gew.-%, bevorzugter 0.5 bis 2 Gew.-%, jeweils bezogen auf die Masse aller von der Zusammensetzung **(B)** umfassten Polyolefincopolymere, eingesetzt.

Photoinitiatoren sind insbesondere ausgewählt aus der Gruppe bestehend aus Benzophenon, Benzanthron, Benzoin, Benzoinalkylether, 2,2-Diethoxyacetophenon, 2,2-Dimethoxy-2-phenylacetophenon, *p*-Phenoxydichloracetophenon, 2-Hydroxycyclohexylphenon, 2-Hydroxyisopropylphenon, 1-Phenylpropandion-2-(ethoxycarbonyl)-oxim.

Der Photoinitiator wird insbesondere in einer Menge von 0.05 bis 10 Gew.-%, bevorzugt 0.1 bis 5 Gew.-%, bevorzugter 0.2 bis 3 Gew.-%, noch bevorzugter 0.25 bis 1 Gew.-%, jeweils bezogen auf die Masse aller von der Zusammensetzung **(B)** umfassten Polyolefincopolymere, eingesetzt.

In einer weiteren bevorzugten Ausführungsform der vorliegenden Erfindung umfasst die Zusammensetzung **(B)** auch mindestens eine weitere Verbindung ausgewählt aus der Gruppe bestehend aus Vernetzern, Silankupplungsmitteln, Antioxidantien, Alterungsschutzmittel, Metalloxiden, Metallhydroxiden, Weißpigmenten; wobei als weitere Verbindung besonders bevorzugt Silankupplungsmittel eingesetzt werden.

Der Begriff "weitere Verbindung" impliziert dabei im Sinne der Erfindung, dass es sich bei dieser Verbindung nicht um Triallylisocyanurat, Triallylcyanurat oder eine Verbindung der chemischen Struktur **(II)** handelt.

Vernetzer sind dabei bevorzugt ausgewählt aus der Gruppe bestehend aus Trimethylolpropantriacrylat, Trimethylolpropantrimethacrylat, Divinylbenzol, Acrylate und Methacrylate von polyhydrischen Alkoholen. Acrylate und Methacrylate von polyhydrischen Alkoholen sind insbesondere ausgewählt aus der Gruppe bestehend aus Ethylenglycoldi(meth)acrylat, Diethylenglycoldi(meth)acrylat, Polyethylenglycoldi(meth)acrylat, Neopentylglycoldi(meth)acrylat, 1,6-Hexandioldi(meth)acrylat, 1,9-Nonandioldi(meth)acrylat, 1,10-Decandioldi(meth)acrylat.

Der Anteil der von der Zusammensetzung **(B)** umfassten Vernetzer ist dabei nicht besonders beschränkt. Der Anteil der Vernetzer in der Zusammensetzung **(B)** liegt insbesondere bei 0.005 bis 5 Gew.-%, bevorzugt 0.01 bis 3 Gew.-%, bevorzugter 0.05 bis 3 Gew.-%, noch bevorzugter 0.1 bis 1.5 Gew.-%, jeweils bezogen auf die Masse aller von der Zusammensetzung **(B)** umfassten Polyolefincopolymere.

Als erfindungsgemäß in der Zusammensetzung **(B)** einsetzbare Silankupplungsmittel kommen alle Silane in Betracht, welche einen ungesättigten Kohlenwasserstoffrest und einen hydrolysierbaren Rest aufweisen (beschrieben etwa in EP 2 436 701 B1, US 5,266,627).

Ungesättigte Kohlenwasserstoffreste sind insbesondere ausgewählt aus der Gruppe bestehend aus Vinyl, Allyl, Isopropenyl, Butenyl, Cyclohexenyl, γ-(Meth)acryloxyallyl.

Hydrolisierbarer Reste sind insbesondere ausgewählt aus der Gruppe bestehend aus Hydrocarbyloxy, Hydrocarbonyloxy, Hydrocarbylamino. Bevorzugt ist der hydrolysierbare Rest ausgewählt aus der Gruppe bestehend aus Methoxy, Ethoxy, Formyloxy, Acetoxy, Proprionyloxy, Alkylamino, Arylamino.

Bevorzugt ist das Silankupplungsmittel ausgewählt aus der Gruppe bestehend aus: Vinyltriethoxysilan, Vinyltris-(β-methoxyethoxy)silan, Vinyltriacetoxysilan, γ-Acryloxypropyltrimethoxysilan, γ-Methacryloxypropyltrimethoxysilan, *N*-(β-aminoethyl)-γ-aminopropyltrimethoxysilan, *N*-(β-Aminoethyl)-γ-aminopropylmethyldimethoxysilan, γ-Aminopropyltriethoxysilan, γ-Glycidoxypropyltrimethoxysilan, γ-Mercaptopropyltriethoxysilan, γ-Chlorpropyltrimetoxysilan, β-(3,4-Ethoxycyclohexyl)-ethyltrimethoxysilan, γ-Mercaptopropyltrimethoxysilan. Besonders bevorzugt wird als Silankupplungsmittel γ-Methacryloxypropyltrimethoxysilan (abgekürzt als "KBM") eingesetzt.

Der Anteil des von der Zusammensetzung **(B)** umfassten Silankupplungsmittels ist dabei nicht besonders beschränkt. Der Anteil aller von der Zusammensetzung **(B)** umfassten Silankupplungsmittel liegt insbesondere bei 0.05 bis 5 Gew.-%, bevorzugt 0.1 bis 2 Gew.-%, jeweils bezogen auf die Masse aller von der Zusammensetzung **(B)** umfassten Polyolefincopolymere.

Antioxidantien sind im Sinne der Erfindung bevorzugt ausgewählt aus der Gruppe bestehend aus phenolischen Antioxidantien, phosphorhaltigen Antioxidantien.

Phenolische Antioxidantien sind insbesondere ausgewählt aus der Gruppe bestehend aus 4-Methoxyphenol, 2,6-Di-*tert*-butyl-4-methylphenol, *tert*-Butylhydrochinon, Stearyl-β-(3,5-di-*tert*-butyl-4-hydroxyphenyl)-propionat, Pentaerythrittetrakis-[3-(3,5-di-*tert*-butyl-4-hydroxyphenyl)-propionat], 3,5-Di-*tert*-butyl-4-hydroxybenzoësäurehexadecylester.

Phosphorhaltige Antioxidantien sind insbesondere ausgewählt aus der Gruppe bestehend aus Triphenylphosphit, Tris-(nonylphenyl)-phosphit, Distearylpentaerythritoldiphosphit, Tetra-(tridecyl)-1,1,3-tris-(2-methyl-5-*tert*-butyl-4-hydroxyphenyl)-butan-diphosphat, Tetrakis-(2,4-di-*tert*-butylphenyl)-4,4-biphenyldiphosphonit.

Der Anteil der von der Zusammensetzung **(B)** umfassten Antioxidantien ist dabei nicht besonders beschränkt. Der Anteil aller von der Zusammensetzung **(B)** umfassten Antioxidantien liegt insbesondere bei 0.01 bis 0.5 Gew.-%, bevorzugt 0.05 bis 0.3 Gew.-%, jeweils bezogen auf die Masse aller von der Zusammensetzung **(B)** umfassten Polyolefincopolymere.

Alterungsschutzmittel sind im Sinne der Erfindung insbesondere ausgewählt aus der Gruppe der "*hindered amine light stabilizers*" (= "HALS")-Stabilisatoren und der UV-Absorber.

HALS-Stabilisatoren sind im Sinne der Erfindung insbesondere Verbindungen, die mindestens einen 2,2,6,6-Tetramethyl-4-piperidyl-Rest aufweisen, wobei das Stickstoffatom an der 1-Position des Piperidylrestes ein H, eine Alkylgruppe oder eine Alkoxygruppe trägt.

Bevorzugt sind HALS-Stabilisatoren ausgewählt aus der Gruppe bestehend aus Bis(2,2,6,6-tetramethyl-4-piperidyl)-sebacat, 1,2,2,6,6-Pentamethyl-4-piperidylsebacat, Bis(1,2,2,6,6-pentamethyl-4-piperidyl)-sebacat, Bis-(1-octyloxy-2,2,6,6-tetramethyl-4-piperidyl)-sebacat, Poly-{(6-morpholino-S-triazin-2,4-diyl)-[2,2,6,6-tetramethyl-4-piperidyl)-imino]- hexamethylen-[(2,2,6 ,6-tetramethyl-4-piperidyl)-imino]} mit der CAS-Nummer 82451-48-7, Polymere der CAS-Nummer 193098-40-7, Copolymer aus Dimethylsuccinat und 1-(2-Hydroxyethyl)-2,2,6,6-tetramentyl-4-piperidinol, *N,N',N",N"'*-Tetrakis-{4,6-bis-[butyl-(*N*-methyl-2,2,6,6-tetramethylpiperidin-4-yl)-amino]-triazin-2-yl}-4,7-diazadecan-1,10-diamin mit der CAS-Nummer 106990-43-6.

Der Anteil der von der Zusammensetzung **(B)** umfassten HALS-Stabilisatoren ist dabei nicht besonders beschränkt. Der Anteil aller von der Zusammensetzung **(B)** umfassten HALS-Stabilisatoren liegt insbesondere bei 0.01 bis 0.5 Gew.-%, bevorzugt 0.05 bis 0.3 Gew.-%, jeweils bezogen auf die Masse aller von der Zusammensetzung **(B)** umfassten Polyolefincopolymere.

UV-Absorber sind insbesondere ausgewählt aus der Gruppe bestehend aus 2-Hydroxy-4-*N*-octoxybenzophenon, 2,4-Di-*tert*-butylphenyl-3,5-di-*tert*-butyl-4-hydroxybenzoat, 2-Hydroxy-4-methoxybenzophenon, 2,2-Dihydroxy-4-methoxybenzophenon, 2-Hydroxy-4-methoxy-4-carboxybenzophenon, 2-(2-Hydroxy-3,5-di-*tert*-butylphenyl)-benzotriazol, 2-(2-Hydroxy-5-methylphenyl)-benzotriazol, p-Octyl-phenyl salicylat, 2-(4,6-Diphenyl-1,3,5-triazine-2-yl)-5-[(hexyl)-oxy]-phenol, Ethyl-2-cyano-3,3-diphenyl-acrylat.

Der Anteil der von der Zusammensetzung **(B)** umfassten UV-Absorber ist dabei nicht besonders beschränkt. Der Anteil aller von der Zusammensetzung **(B)** umfassten UV-Absorber liegt insbesondere bei 0.01 bis 0.5 Gew.-%, bevorzugt 0.05 bis 0.3 Gew.-%, jeweils bezogen auf die Masse aller von der Zusammensetzung **(B)** umfassten Polyolefincopolymere.

Metalloxide sind erfindungsgemäß insbesondere ausgewählt aus der Gruppe bestehend aus Alkalimetalloxiden, Erdalkalimetalloxiden, Zinkoxid, bevorzugt ausgewählt aus der Gruppe bestehend aus Magnesiumoxid, Zinkoxid.

Der Anteil der von der Zusammensetzung **(B)** umfassten Metalloxide ist dabei nicht besonders beschränkt. Der Anteil aller von der Zusammensetzung **(B)** umfassten Metalloxide liegt insbesondere bei 0.01 bis 10 Gew.-%, bevorzugt 0.05 bis 3 Gew.-%, jeweils bezogen auf die Masse aller von der Zusammensetzung **(B)** umfassten Polyolefincopolymere.

Metallhydroxide sind erfindungsgemäß insbesondere ausgewählt aus der Gruppe bestehend aus Alkalimetallhydroxiden, Erdalkalimetallhydroxiden, bevorzugt ausgewählt aus der Gruppe bestehend aus Magnesiumhydroxid, Calciumhydroxid.

Der Anteil der von der Zusammensetzung **(B)** umfassten Metallhydroxide ist dabei nicht besonders beschränkt. Der Anteil aller von der Zusammensetzung **(B)** umfassten Metallhydroxide liegt insbesondere bei 0.01 bis 10 Gew.-%, bevorzugt 0.05 bis 3 Gew.-%, jeweils bezogen auf die Masse aller von der Zusammensetzung **(B)** umfassten Polyolefincopolymere.

Weißpigmente sind im Sinne der Erfindung insbesondere ausgewählt aus der Gruppe Titandioxid, Zinkoxid, Zinksulfid, Bariumsulfat, Lithopone.

Der Anteil der von der Zusammensetzung **(B)** umfassten Weißpigmente ist dabei nicht besonders beschränkt. Der Anteil aller von der Zusammensetzung **(B)** Weißpigmente liegt insbesondere bei 5 bis 25 Gew.-%, bevorzugt 10 bis 20 Gew.-%, noch bevorzugter bei 15 Gew.-%, jeweils bezogen auf die Masse aller von der Zusammensetzung **(B)** umfassten Polyolefincopolymere.

Die Polymerzusammensetzung **(B)** wird in einem weiteren Aspekt der vorliegenden Erfindung zur Herstellung einer Folie zur Verkapselung einer elektronischen Vorrichtung, insbesondere einer Solarzelle, verwendet.

Dabei wird die Zusammensetzung **(B)** zunächst durch Mischen der Zusammensetzung **(A)** sowie den jeweiligen Additiven und dem Polyolefincopolymer hergestellt. Dies erfolgt insbesondere durch Zugabe der Additive in flüssiger Form, d.h. rein oder als Lösung in einem Lösungsmittel, zu der Zusammensetzung **(B)** in einem Mischer. Danach wird so lange gerührt oder die Mischung in Bewegung gehalten, bis die Flüssigkeit vollständig vom Polymergranulat absorbiert worden ist. Eventuell verwendete Lösemittel werden dann wieder durch Anlegen eines Vakuums entfernt.

In einem zweiten Schritt wird die Polymerformulierung über einen Extruder zu einem Film extrudiert. Hierbei wird die Zusammensetzung **(B)** kontinuierlich über eine Dosierschnecke in einen Extruder dosiert in dem das Polymer aufschmilzt und die Additive durch das Kneten der Mischung homogen in der Polymermatrix verteilt werden. Am Ende des Extruders wird die Schmelze durch eine Breitschlitzdüse gepresst. Nach der Düse wird die Folie durch ein Walzwerk abgezogen, nachgekühlt und aufgewickelt.

Alternativ können die Additive oder die Additivmischung auch direkt über den Einfüllstutzen oder über eine Seitendosierung in den Filmextruder dosiert werden.

Die nachfolgenden Beispiele sollen die vorliegende Erfindung weiter erläutern, ohne dass diese auf diese Beispiele beschränkt sein soll.

### Beispiele

### Verwendete Abkürzungen

γ-Methacryloxypropyltrimethoxysilan = KBM.
*tert*-Butylperoxy-2-ethylhexylcarbonat =TBPEHC.
Triallylisocyanurat = TAIC.
Triallylcyanurat = TAC.

### Verwendete Chemikalien

Bei dem im Folgenden verwendeten Triallylisocyanurat handelte es sich um "TAICROS ®" der Evonik Industries AG.

Bei dem im Folgenden verwendeten Triallylcyanurat handelte es sich um "TAC" der Evonik Industries AG.

Bei dem im Folgenden verwendeten γ-Methacryloxypropyltrimethoxysilan handelte es sich um "Dynasylan Memo ®" der Evonik Industries AG.

Bei dem im Folgenden verwendeten EVA handelte es sich um "EVATANE 28-40" ® von Arkema mit einem Gehalt an Vinylacetat von 28.3 Gew.-%.

Das im Folgenden verwendete *tert*-Butylperoxy-2-ethylhexylcarbonat (="TBPEHC") wurde von der Firma United Initiators erworben.

Diallyl-*N*-propyl-isocyanurat (CAS: 5320-25-2) wurde bezogen von ABCR GmbH.

Iminodiessigsäure-diethylester (CAS: 6290-05-7) wurde bezogen von ABCR GmbH.

Allylamin (CAS: 107-11-9) wurde bezogen von ABCR GmbH.

### 1. Synthesen

### 1.1 Triallylbiuret

Triallylbiuret wurde durch Ringöffnung von Triallylisocyanurat im wässrig-alkalischem Medium wie folgt erhalten:
In einem 3 L-Doppelmantelreaktor mit Flügelrührer wurden 830 g (20.8 mol) einer 40 %-igen NaOH-Lösung sowie 1330 g (73.8 mol) Wasser vorgelegt und auf 95 °C erhitzt. Nach Zugabe von 800 g (3.2 mol) Triallylisocyanurat wurde die kolloidale Lösung für 4 Stunden bei 95 °C intensiv gerührt. Die organische Phase wurde mehrmals mit destilliertem Wasser gewaschen und anschließend im Vakuum getrocknet. Die Ausbeute betrug 677.2 g (3.03 mol) Triallylbiuret mit einer Reinheit von 97.4 % (bestimmt per Gaschromatographie).

### 1.2 N-Propyl-diallylbiuret

*N*-Propyl-diallylbiuret wurde durch Ringöffnung von Diallyl-*N*-propyl-isocyanurat im wässrig-alkalischem Medium wie folgt erhalten:
1.0 g (4.0 mmol) Diallyl-*N*-propyl-isocyanurat wurden in 1.5 g Wasser und 1.0 g 40 %-iger NaOH intensiv bei 95 °Cfür 15 Stunden gerührt. Man erhielt das Produkt mit 96 %-iger Ausbeute. Die Aufreinigung erfolgte durch mehrfaches Waschen mit destilliertem Wasser.

### 1.3 Imino-di-(essigsäure-N-allylamid):

2 g (10.6 mmol) Iminodiessigsäure-diethylester (CAS: 6290-05-7) und 3 g (52 mmol) Allylamin (CAS: 107-11-9) wurden in einem Druckreaktor vorgelegt und anschließend bei 90 - 100 °C für 2 - 3 Stunden erhitzt. Anschließend wurde freigesetztes Ethanol und überschüssiges Allylamin fraktioniert abdestilliert und das abgetrennte Allylamin anschließend der Reaktionslösung erneut zugeführt. Das Reaktionsgemisch wurde nochmals für 2 - 3 Stunden erhitzt und die Prozedur 3 mal bis zum vollständigen Umsatz wiederholt (vollständiger Umsatz per HPLC bestimmt). Reste von Ethanol und Allylamin wurden im Vakuum entfernt.

### 2. Herstellung der Beispiel-Formulierungen

### 2.1 Vergleichsbeispiel V1

2.5 g (10.0 mmol) Triallylisocyanurat wurden mit 0.5 g KBM und 4.0 g TBPEHC homogen vermischt. Die Mischung wurde auf 493 g EVA gleichmäßig verteilt und die so erhaltene Additivmischung anschließend für 2 bis 4 Stunden in einem Taumelmischer durchmischt.

### Beispiel 1

2.48 g (9.95 mmol) TAIC wurden zusammen mit 0.05 g (0.23 mmol) Triallylbiuret (Molare Masse: 223.27 g/mol), 0.5 g KBM und 4.0 g TBPEHC homogen vermischt. Die Mischung wurde auf 493 g EVA gleichmäßig verteilt und die so erhaltene Additivmischung anschließend für 2 bis 4 Stunden in einem Taumelmischer durchmischt.

### Beispiel 2

2.42 g (9.73 mmol) TAIC wurden zusammen mit 0.076 g (0.34 mmol) Triallylbiuret, 0.5 g KBM und 4.0 g TBPEHC homogen vermischt. Die Mischung wurde auf 493 g EVA gleichmäßig verteilt und die so erhaltene Additivmischung anschließend für 2 bis 4 Stunden in einem Taumelmischer durchmischt.

### Beispiel 3

2.38 g (9.53 mmol) TAIC wurden zusammen mit 0.125 g (0.56 mmol) Triallylbiuret, 0.5 g KBM und 4.0 g TBPEHC homogen vermischt. Die Mischung wurde auf 493 g EVA gleichmäßig verteilt und die so erhaltene Additivmischung anschließend für 2 bis 4 Stunden in einem Taumelmischer durchmischt.

### Beispiel 4

2.35 g (9.43 mmol) TAIC wurden zusammen mit 0.150 g (0.67 mmol) Triallylbiuret, 0.5 g KBM und 4.0 g TBPEHC homogen vermischt. Die Mischung wurde auf 493 g EVA gleichmäßig verteilt und die so erhaltene Additivmischung anschließend für 2 bis 4 Stunden in einem Taumelmischer durchmischt.

### Beispiel 5

2.25 g (9.03 mmol) TAIC wurden zusammen mit 0.250 g (1.12 mmol) Triallylbiuret, 0.5 g KBM und 4.0 g TBPEHC homogen vermischt. Die Mischung wurde auf 493 g EVA gleichmäßig verteilt und die so erhaltene Additivmischung anschließend für 2 bis 4 Stunden in einem Taumelmischer durchmischt.

### Beispiel 6

2.00 g (8.02 mmol) TAIC wurden zusammen mit 0.500 g (2.24 mmol) Triallylbiuret, 0.5 g KBM und 4.0 g TBPEHC homogen vermischt. Die Mischung wurde auf 493 g EVA gleichmäßig verteilt und die so erhaltene Additivmischung anschließend für 2 bis 4 Stunden in einem Taumelmischer durchmischt.

### Beispiel 7

2.45 g (9.83 mmol) TAIC wurden zusammen mit 0.04 g (0.19 mmol) *N*-Propyl-diallylbiuret (Molare Masse: 225.27 g/mol), 0.5 g KBM und 4.0 g TBPEHC homogen vermischt. Die Mischung wurde auf 493 g EVA gleichmäßig verteilt und die so erhaltene Additivmischung anschließend für 2 bis 4 Stunden in einem Taumelmischer durchmischt.

### Beispiel 8

2.47 g (9.93 mmol) TAIC wurden zusammen mit 0.025 g (0.12 mmol) Imino-di-(essigsäure-*N-*allylamid) (Molare Masse: 211.25 g/mol), 0.5 g KBM und 4.0 g TBPEHC homogen vermischt. Die Mischung wurde auf 493 g EVA gleichmäßig verteilt und die so erhaltene Additivmischung anschließend für 2 bis 4 Stunden in einem Taumelmischer durchmischt.

### Beispiel 9

2.45 g (9.83 mmol) TAIC wurden zusammen mit 0.052 g (0.25 mmol) Imino-di-(essigsäure-*N-*allylamid), 0.5 g KBM und 4.0 g TBPEHC homogen vermischt. Die Mischung wurde auf 493 g EVA gleichmäßig verteilt und die so erhaltene Additivmischung anschließend für 2 bis 4 Stunden in einem Taumelmischer durchmischt.

### Beispiel 10

2.40 g (9.63 mmol) TAIC wurden zusammen mit 0.106 g (0.50 mmol) Imino-di-(essigsäure-*N-*allylamid), 0.5 g KBM und 4.0 g TBPEHC homogen vermischt. Die Mischung wurde auf 493 g EVA gleichmäßig verteilt und die so erhaltene Additivmischung anschließend für 2 bis 4 Stunden in einem Taumelmischer durchmischt.

### Vergleichsbeispiel V2

2.5 g (10 mmol) Triallylcyanurat (= "TAC") wurden mit 0.5 g KBM und 4.0 g TBPEHC homogen vermischt. Die Mischung wurde auf 493 g EVA gleichmäßig verteilt und die so erhaltene Additivmischung anschließend für 2 bis 4 Stunden in einem Taumelmischer durchmischt.

### Beispiel 11

2.43 g (9.73 mmol) TAC wurden zusammen mit 0.075 g (0.34 mmol) Triallylbiuret, 0.5 g KBM und 4.0 g TBPEHC homogen vermischt. Die Mischung wurde auf 493 g EVA gleichmäßig verteilt und die so erhaltene Additivmischung anschließend für 2 bis 4 Stunden in einem Taumelmischer durchmischt.

### Beispiel 12

2.38 g (9.53 mmol) TAC wurden zusammen mit 0.125 g (0.56 mmol) Triallylbiuret, 0.5 g KBM und 4.0 g TBPEHC homogen vermischt. Die Mischung wurde auf 493 g EVA gleichmäßig verteilt und die so erhaltene Additivmischung anschließend für 2 bis 4 Stunden in einem Taumelmischer durchmischt.

### Beispiel 13

2.25 g (9.03 mmol) TAC wurden zusammen mit 0.25 g (1.11 mmol) Triallylbiuret, 0.5 g KBM und 4.0 g TBPEHC homogen vermischt. Die Mischung wurde auf 493 g EVA gleichmäßig verteilt und die so erhaltene Additivmischung anschließend für 2 bis 4 Stunden in einem Taumelmischer durchmischt.

### 3. Folienextrusion

Zur Herstellung der EVA-Folien wurde das konditionierte EVA-Granulat, welches wie in den Beispielen V1, V2, 1 - 13 beschrieben hergestellt worden war, volumetrisch in einem Doppelschnecken-Laborextruder (Collin) dosiert. Die EVA Schmelze wurde über eine Breitschlitzdüse (10 cm) mit einstellbarer Spaltdicke verdüst, die Folie kontinuierlich auf einem Walzwerk auf 20 °C nachgekühlt und anschließend aufgewickelt. Die Extruder-Einstellungen sind nachstehend aufgeführt:

**Extrusionsparameter für EVA-Folienherstellung**

| Temperatur Heizzonen [°C] | |
|---|---|
| T1 | 70 |
| T2 | 77 |
| T3 | 77 |
| T4 | 75 |
| T5 | 80 |
| Düse | 80 |
| T(Schmelze) | 87-90 |

### 4. Folienlamination

Die Lamination der EVA-Folie wurde bei 150 °C (Maschineneinstellung) zwischen Teflon-Trennfolien durchgeführt, wobei die entsprechende Temperatur über den gesamten Laminationsprozess konstant gehalten wurde. Die Dauer des einstufigen Entgasungsschrittes betrug 100 s. Anschließend wurde die Probe mit einem Anpressdruck von 0.7 kg/cm² verpresst. Die Verweilzeit im Laminator betrug 20 Minuten.

### 5. Bestimmung des spezifischen Widerstands ρ

Für die Bestimmung des Widerstandes von vernetzten, 400 bis 500 µm starken EVA Folien wurden zunächst Proben mit den Abmaßen ca. 8 x 8 cm bei Raumtemperatur (22.5 °C) und einer relativen Luftfeuchte von 50 % 7 Tage gelagert, um ein konstantes Feuchtigkeitslevel innerhalb des EVA Films zu gewährleisten.

Die Widerstandsmessung wurde mit einem Ohmmeter der Firma Keithley (6517B) und einer entsprechenden Messzelle, ebenfalls von Keithley ("*resistivity test fixture 8009*"), durchgeführt. Nach ASTM D-257 wurde die Probe mit einer Spannung von 500 V für 60 s beaufschlagt und nach dieser Zeit der Strom gemessen. Der Widerstand (VR) lässt sich dann aus den bekannten Größen berechnen.

### 6. Ergebnisse der Widerstandsmessungen der Beispielformulierungen

### 6.1 Vergleichsbeispiel V1, erfindungsgemäße Beispiele 1 bis 10

Die nachfolgende Tabelle 1 gibt die VR-Werte an, die mit dem gemäß Vergleichsbeispiel V1 erhaltenen EVA-Granulat und den gemäß erfindungsgemäßen Beispielen 1 bis 10 erhaltenen EVA-Granulaten hergestellten Folien gemessen wurden. Das Covernetzersystem umfasste dabei TAIC und das jeweils in Tabelle 1 angegebene Vernetzungsadditiv in den ebenfalls in Tabelle 1 angegebenen Mengen.

**Tabelle 1:**

| Beispiel Nr. | TAIC in mmol; Gewicht in "[ ]" | Vernetzungsadditive Typ | Additiv in mmol; Gewicht in "[ ]" | Anteil Additiv bez. auf TAIC in mol.-% | Anteil Additiv bez. auf TAIC in Gew.-% | VR * 10¹⁵ [Ohm*cm] |
|---|---|---|---|---|---|---|
| V1 | 10.0 [2.50 g] | | 0 | 0 | | 3.77 |
| 1 | 9.95 [2.48 g] | Triallylbiuret | 0.23 [0.05 g] | 2.3 | 2.1 | 5.15 |
| 2 | 9.73 [2.42 g] | Triallylbiuret | 0.34 [0.076 g] | 3.5 | 3.1 | 32.22 |
| 3 | 9.53 [2.38 g] | Triallylbiuret | 0.56 [0.125 g] | 5.9 | 5.3 | 16.73 |
| 4 | 9.43 [2.35 g] | Triallylbiuret | 0.67 [0.150 g] | 7.1 | 6.4 | 12.39 |
| 5 | 9.03 [2.25 g] | Triallylbiuret | 1.12 [0.250 g] | 12.4 | 11.1 | 10.45 |
| 6 | 8.02 [2.00 g] | Triallylbiuret | 2.24 [0.500 g] | 27.9 | 25.0 | 14.14 |
| 7 | 9.83 [2.45 g] | *N*-Propyl-diallylbiuret | 0.19 [0.04 g] | 1.9 | 1.7 | 5.92 |
| 8 | 9.93 [2.47 g] | Imino-di-(essigsäure-*N-*allylamid) | 0.12 [0.025 g] | 1.2 | 1.0 | 5.90 |
| 9 | 9.83 [2.45 g] | Imino-di-(essigsäure-*N-*allylamid) | 0.25 [0.052 g] | 2.5 | 2.2 | 8.12 |
| 10 | 9.63 [2.40 g] | Imino-di-(essigsäure-*N-*allylamid) | 0.50 [0.106 g] | 5.2 | 4.4 | 10.57 |

### 6.2 Vergleichsbeispiel V2, erfindungsgemäße Beispiele 11 bis 13

Die nachfolgende Tabelle 2 gibt die VR-Werte an, die mit dem gemäß Vergleichsbeispiel V2 erhaltenen EVA-Granulat und den gemäß erfindungsgemäßen Beispielen 11 bis 13 erhaltenen EVA-Granulaten hergestellten Folien gemessen wurden. Das jeweilige Covernetzersystem umfasste dabei TAC und Triallylbiuret in den in Tabelle 2 angegebenen Mengen.

**Tabelle 2:**

| Beispiel Nr. | TAC in mmol; Gewicht in "[ ]" | Triallylbiuret in mmol; Gewicht in "[ ]" | Anteil Triallylbiuret bez. auf TAC in mol.-% | Anteil Triallylbiuret bez. auf TAC in Gew.-% | VR* 1015 [Ohm*cm] |
|---|---|---|---|---|---|
| V2 | 10.0 [2.5 g] | - | - | - | 4.2 |
| 11 | 9.73 [2.43 g] | 0.34 [0.075 g] | 3.5 | 3.1 | 16.94 |
| 12 | 9.53 [2.38 g] | 0.56 [0.125 g] | 5.9 | 5.3 | 17.91 |
| 13 | 9.03 [2.25 g] | 1.11 [0.25 g] | 12.3 | 11.1 | 10.65 |

Die in Tabellen 1 und 2 dargestellten Ergebnisse belegen, dass mit dem erfindungsgemäßen Covernetzersystem, also Zusammensetzung **(A)**, Folien mit einem hohen spezifischen Widerstand erhalten werden können. So sind sämtliche VR-Werte der mit dem erfindungsgemäßen Covernetzersystem hergestellten Folien höher als der Wert der Folie, die mit einem Vernetzer des Standes der Technik, TAIC bzw. TAC, erhalten wurde.

## Patentansprüche

1. Zusammensetzung **(A)** umfassend
(i) mindestens eine Verbindung **(I)** ausgewählt aus der Gruppe bestehend aus Triallylisocyanurat, Triallylcyanurat; und
(ii) mindestens eine Verbindung **(II)**, welche allgemein durch die Strukturformel: 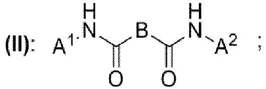 definiert ist:
wobei
A¹, A² unabhängig voneinander jeweils ausgewählt sind aus der Gruppe bestehend aus
unverzweigte oder verzweigte Alkenylgruppe mit 3 bis 18 Kohlenstoffatomen, welche mindestens eine terminale Doppelbindung aufweist,
eine Gruppe der chemischen Struktur **(III)** mit 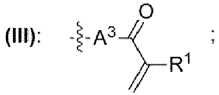 wobei
R¹ = Wasserstoff oder Methyl ist;
A³ eine unverzweigte oder verzweigte Alkylengruppe mit 1 bis 12 Kohlenstoffatomen ist;
B ausgewählt aus der Gruppe bestehend aus -NR²-, der chemischen Struktur -(CH₂)ₚ-NR³-(CH₂)_{q}-, und der chemischen Struktur **(IV)** mit 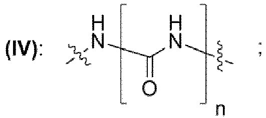 ist,
wobei R², R³ unabhängig voneinander jeweils ausgewählt sind aus der Gruppe bestehend aus Wasserstoff, Alkylgruppe mit 1 bis 20 Kohlenstoffatomen, unverzweigte oder verzweigte Alkenylgruppe mit 3 bis 18 Kohlenstoffatomen, welche mindestens eine terminale Doppelbindung aufweist,
eine Gruppe der chemischen Struktur **(V)** mit 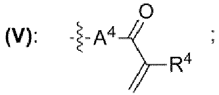 wobei
R⁴ = Wasserstoff oder Methyl ist;
A⁴ eine unverzweigte oder verzweigte Alkylengruppe mit 1 bis 12 Kohlenstoffatomen ist;
und wobei n, p, q unabhängig voneinander jeweils eine ganze Zahl im Bereich 1 bis 5 ist;
und wobei mindestens eine von der Zusammensetzung **(A)** umfasste Verbindung **(II)** in einem Anteil von mindestens 1 Gew.-%, bezogen auf das Gesamtgewicht aller von der Zusammensetzung **(A)** umfassten Verbindungen **(I)**, vorliegt.

2. Zusammensetzung **(A)** nach Anspruch 1, wobei die Verbindung **(I)** Triallylisocyanurat ist.

3. Zusammensetzung **(A)** nach Anspruch 1 oder 2, wobei A¹, A² unabhängig voneinander jeweils ausgewählt sind aus der Gruppe bestehend aus Allylgruppe, Methallylgruppe, einer Gruppe der chemischen Struktur **(III)** mit 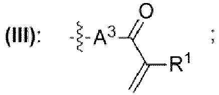 wobei
R¹ = Wasserstoff oder Methyl ist;
A³ eine unverzweigte oder verzweigte Alkylengruppe mit 1 bis 6 Kohlenstoffatomen ist;
B ausgewählt aus der Gruppe bestehend aus -NR²-, -CH₂-NH-CH₂-, und der chemischen Struktur **(IV)** mit 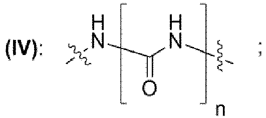 ist,
wobei R² ausgewählt aus der Gruppe bestehend aus Wasserstoff, Alkylgruppe mit 1 bis 20 Kohlenstoffatomen, Allylgruppe, Methallylgruppe,
eine Gruppe der chemischen Struktur **(V)** mit 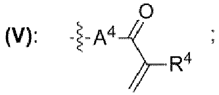 ist, wobei
R⁴ = Wasserstoff oder Methyl ist;
A⁴ eine unverzweigte oder verzweigte Alkylengruppe mit 1 bis 6 Kohlenstoffatomen ist;
und wobei n eine ganze Zahl im Bereich 1 bis 3 ist.

4. Zusammensetzung **(A)** nach Anspruch 3, wobei die Verbindung **(II)** ausgewählt ist aus der Gruppe bestehend aus den chemischen Strukturen **(VI)**, **(VII)**, **(VIII)**, **(IX)**, **(X)** mit 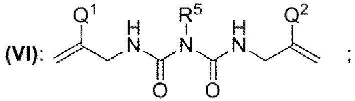 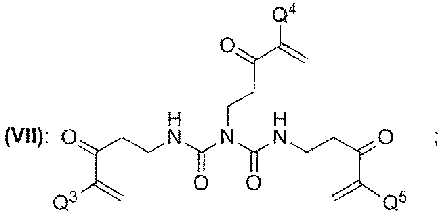 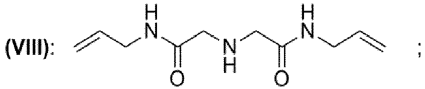 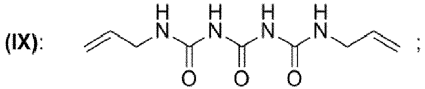 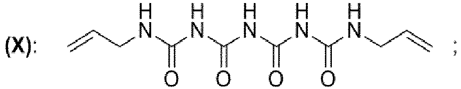
wobei R⁵ ausgewählt aus der Gruppe bestehend aus
Wasserstoff, Alkylgruppe mit 1 bis 20 Kohlenstoffatomen, Allylgruppe, Methallylgruppe ist;
und wobei Q¹, Q², Q³, Q⁴, Q⁵ unabhängig voneinander jeweils Wasserstoff oder Methyl ist.

5. Zusammensetzung **(A)** nach einem der Ansprüche 1 bis 4, wobei das Gesamtgewicht aller von der Zusammensetzung **(A)** umfassten Verbindungen **(II)** 1 bis 50 Gew.-%, bezogen auf das Gesamtgewicht aller von der Zusammensetzung **(A)** umfassten Verbindungen **(I)**, beträgt.

6. Zusammensetzung **(B)** umfassend mindestens ein Polyolefincopolymer und eine Zusammensetzung **(A)** nach einem der Ansprüche 1 bis 5.

7. Zusammensetzung **(B)** nach Anspruch 6, wobei das Polyolefincopolymer ein Ethylen-Vinylacetat-Copolymer ist.

8. Zusammensetzung **(B)** nach Anspruch 7, wobei das Ethylen-Vinylacetat-Copolymer einen Vinylacetatgehalt von 15 bis 50 Gew.-%, bezogen auf das Gesamtgewicht des Ethylen-Vinylacetat-Copolymers, bestimmt nach ASTM D 5594:1998, aufweist.

9. Zusammensetzung **(B)** nach einem der Ansprüche 6 bis 8, worin der Anteil an Zusammensetzung **(A)** bei 0.05 bis 10 Gew.-%, bezogen auf die Masse aller von der Zusammensetzung **(B)** umfassten Polyolefincopolymere, liegt.

10. Zusammensetzung **(B)** nach einem der Ansprüche 6 bis 9, welche zusätzlich mindestens einen Initiator ausgewählt aus der Gruppe bestehend aus peroxidischen Verbindungen, Azoverbindungen, Photoinitiatoren umfasst.

11. Zusammensetzung **(B)** nach Anspruch 10, wobei der Initiator eine peroxidische Verbindung ist.

12. Zusammensetzung **(B)** nach einem der Ansprüche 6 bis 11, welche zusätzlich mindestens eine weitere Verbindung ausgewählt aus der Gruppe bestehend aus Vernetzern, Silankupplungsmitteln, Antioxidantien, Alterungsschutzmitteln, Metalloxiden, Metallhydroxiden, Weißpigmenten umfasst.

13. Zusammensetzung **(B)** nach Anspruch 12, wobei die weitere Verbindung ein Silankupplungsmittel ist.

14. Verwendung einer Zusammensetzung **(B)** nach einem der Ansprüche 6 bis 13 zur Herstellung einer Folie zur Verkapselung einer elektronischen Vorrichtung.

## Claims

1. Composition **(A)** comprising
(i) at least one compound **(I)** selected from the group consisting of triallyl isocyanurate, triallyl cyanurate; and
(ii) at least one compound **(II)** defined in general terms by the structural formula: 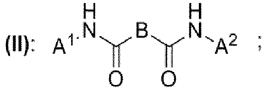 where
A¹, A² are each independently selected from the group consisting of
unbranched or branched alkenyl group which has 3 to 18 carbon atoms and at least one terminal double bond,
a group of the chemical structure **(III)** with 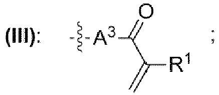 where
R¹ = hydrogen or methyl;
A³ is an unbranched or branched alkylene group having 1 to 12 carbon atoms;
B is selected from the group consisting of -NR²-, the chemical structure -(CH₂)ₚ-NR³-(CH₂)_{q}- and the chemical structure (IV) with 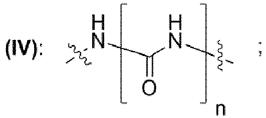
where R², R³ are each independently selected from the group consisting of hydrogen, alkyl group having 1 to 20 carbon atoms, unbranched or branched alkenyl group which has 3 to 18 carbon atoms and at least one terminal double bond,
a group of the chemical structure **(V)** with 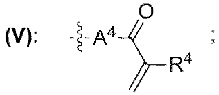 where
R⁴ = hydrogen or methyl;
A⁴ is an unbranched or branched alkylene group having 1 to 12 carbon atoms;
and where n, p, q are each independently an integer in the range of 1 to 5;
and where at least one compound **(II)** encompassed by the composition **(A)** is present in a proportion of at least 1% by weight based on the total weight of all the compounds **(I)** encompassed by the composition **(A)**.

2. Composition **(A)** according to Claim 1, wherein the compound **(I)** is triallyl isocyanurate.

3. Composition **(A)** according to Claim 1 or 2, wherein A¹, A² are each independently selected from the group consisting of allyl group, methallyl group, a group of the chemical structure **(III)** with 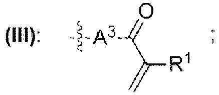 where
R¹ = hydrogen or methyl;
A³ is an unbranched or branched alkylene group having 1 to 6 carbon atoms;
B is selected from the group consisting of -NR²-, -CH₂-NH-CH₂-, and the chemical structure **(IV)** with 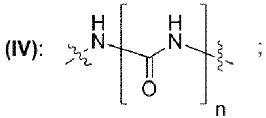 where R² is selected from the group consisting of hydrogen, alkyl group having 1 to 20 carbon atoms, allyl group, methallyl group,
a group of the chemical structure **(V)** with 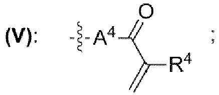 where
R⁴ = hydrogen or methyl;
A⁴ is an unbranched or branched alkylene group having 1 to 6 carbon atoms;
and where n is an integer in the range of 1 to 3.

4. Composition **(A)** according to Claim 3, wherein the compound **(II)** is selected from the group consisting of the chemical structures **(VI)**, **(VII)**, **(VIII)**, **(IX)**, **(X)** with 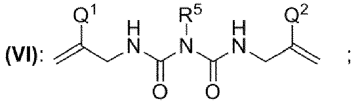 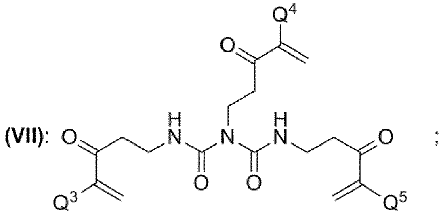 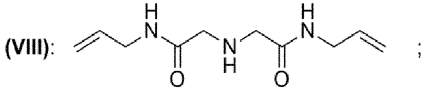 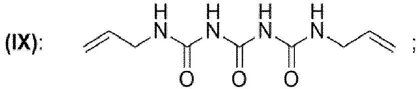 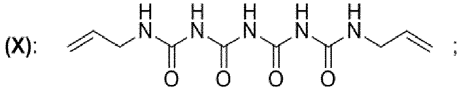 where R⁵ is selected from the group consisting of
hydrogen, alkyl group having 1 to 20 carbon atoms, allyl group, methallyl group;
and where Q¹, Q², Q³, Q⁴, Q⁵ are each independently hydrogen or methyl.

5. Composition **(A)** according to any of Claims 1 to 4, wherein the total weight of all the compounds **(II)** encompassed by the composition **(A)** is 1% to 50% by weight, based on the total weight of all the compounds **(I)** encompassed by the composition **(A)**.

6. Composition **(B)** comprising at least one polyolefin copolymer and a composition **(A)** according to any of Claims 1 to 5.

7. Composition **(B)** according to Claim 6, wherein the polyolefin copolymer is an ethylene-vinyl acetate copolymer.

8. Composition **(B)** according to Claim 7, wherein the ethylene-vinyl acetate copolymer has a vinyl acetate content of 15% to 50% by weight, based on the total weight of the ethylene-vinyl acetate copolymer, determined to ASTM D 5594:1998.

9. Composition **(B)** according to any of Claims 6 to 8, in which the proportion of composition **(A)** is 0.05% to 10% by weight, based on the mass of all the polyolefin copolymers encompassed by the composition **(B)**.

10. Composition **(B)** according to any of Claims 6 to 9, additionally comprising at least one initiator selected from the group consisting of peroxidic compounds, azo compounds, photoinitiators.

11. Composition **(B)** according to Claim 10, wherein the initiator is a peroxidic compound.

12. Composition **(B)** according to any of Claims 6 to 11, additionally comprising at least one further compound selected from the group consisting of crosslinkers, silane coupling agents, antioxidants, ageing stabilizers, metal oxides, metal hydroxides, white pigments.

13. Composition **(B)** according to Claim 12, wherein the further compound is a silane coupling agent.

14. Use of a composition **(B)** according to any of Claims 6 to 13 for production of a film for encapsulation of an electronic device.

## Revendications

1. Composition (A) comprenant
(i) au moins un composé (I) choisi dans le groupe constitué par l'isocyanurate de triallyle, le cyanurate de triallyle ; et
(ii) au moins un composé (II), qui est défini de manière générale par la formule développée : 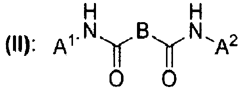 dans laquelle
A¹, A² sont choisis, indépendamment l'un de l'autre, à chaque fois dans le groupe constitué par un groupe alcényle non ramifié ou ramifié, comprenant 3 à 18 atomes de carbone, qui présente au moins une double liaison terminale,
un groupe de structure chimique (III) avec 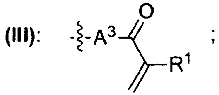 dans laquelle
R¹ représente hydrogène ou méthyle ;
A³ représente un groupe alkylène non ramifié ou ramifié comprenant 1 à 12 atomes de carbone ;
B est choisi dans le groupe constitué par -NR²-, la structure chimique - (CH₂) p-NR³-(CH₂)q- et la structure chimique (IV) avec 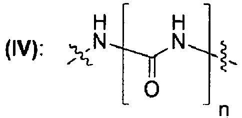 dans lesquels R², R³, indépendamment l'un de l'autre, sont choisis à chaque fois dans le groupe constitué par hydrogène, un groupe alkyle comprenant 1 à 20 atomes de carbone, un groupe alcényle non ramifié ou ramifié comprenant 3 à 18 atomes de carbone, qui présente au moins une double liaison terminale,
un groupe de structure chimique (V) avec 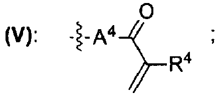 dans laquelle
R⁴ représente hydrogène ou méthyle ;
A⁴ représente un groupe alkylène non ramifié ou ramifié comprenant 1 à 12 atomes de carbone ; et n, p, q, indépendamment les uns des autres, représentent à chaque fois un nombre entier dans la plage de 1 à 5 ;
et au moins un composé (II) faisant partie de la composition (A) se trouvant en une proportion d'au moins 1% en poids, par rapport au poids total de tous les composés (I) faisant partie de la composition (A).

2. Composition (A) selon la revendication 1, le composé (I) étant l'isocyanurate de triallyle.

3. Composition (A) selon la revendication 1 ou 2, A¹, A² étant choisis, indépendamment l'un de l'autre, à chaque fois dans le groupe constitué par un groupe allyle, un groupe méthallyle, un groupe de structure chimique (III), avec 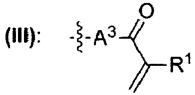 dans laquelle
R¹ représente hydrogène ou méthyle ;
A³ représente un groupe alkylène non ramifié ou ramifié comprenant 1 à 6 atomes de carbone ;
B est choisi dans le groupe constitué par -NR²-, -CH₂-NH-CH₂- et la structure chimique (IV) avec 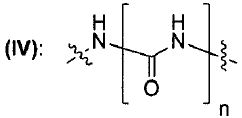 dans laquelle R² est choisi dans le groupe constitué par hydrogène, un groupe alkyle comprenant 1 à 20 atomes de carbone, un groupe allyle, un groupe méthallyle,
un groupe de structure chimique (V) avec 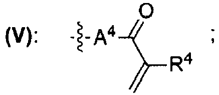 dans laquelle
R⁴ représente hydrogène ou méthyle ;
A⁴ représente un groupe alkylène non ramifié ou ramifié comprenant 1 à 6 atomes de carbone ;
et n représente un nombre entier de la plage de 1 à 3.

4. Composition (A) selon la revendication 3, le composé (II) étant choisi dans le groupe constitué par les structures chimiques (VI), (VII), (VIII), (IX), (X) avec 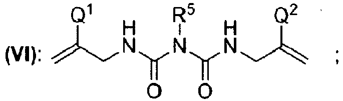 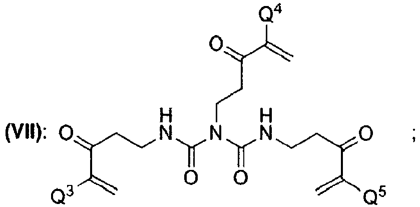 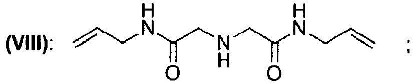 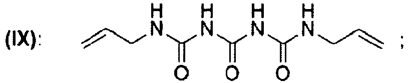 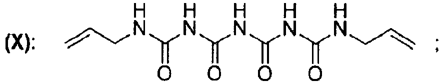
dans lesquelles R⁵ est choisi dans le groupe constitué par
hydrogène, un groupe alkyle comprenant 1 à 20 atomes de carbone, un groupe allyle, un groupe méthallyle ;
et Q¹, Q², Q³, Q⁴, Q⁵ représentent, indépendamment les uns des autres, à chaque fois hydrogène ou méthyle.

5. Composition (A) selon l'une quelconque des revendications 1 à 4, le poids total de tous les composés (II) faisant partie de la composition (A) représentant 1 à 50% en poids, par rapport au poids total de tous les composés (I) faisant partie de la composition (A).

6. Composition (B) comprenant au moins un copolymère polyoléfinique et une composition (A) selon l'une quelconque des revendications 1 à 5.

7. Composition (B) selon la revendication 6, le copolymère polyoléfinique étant un copolymère d'éthylène-acétate de vinyle.

8. Composition (B) selon la revendication 7, le copolymère d'éthylène-acétate de vinyle présentant une teneur en acétate de vinyle de 15 à 50% en poids, par rapport au poids total du copolymère d'éthylène-acétate de vinyle, déterminée selon la norme ASTM D 5594:1998.

9. Composition (B) selon l'une quelconque des revendications 6 à 8, la proportion de composition (A) représentant 0,05 à 10% en poids, par rapport à la masse de tous les copolymères polyoléfiniques faisant partie de la composition (B).

10. Composition (B) selon l'une quelconque des revendications 6 à 9, qui comprend en outre au moins un initiateur choisi dans le groupe constitué par les composés peroxydes, les composés azo, les photo-initiateurs.

11. Composition (B) selon la revendication 10, l'initiateur étant un composé peroxyde.

12. Composition (B) selon l'une quelconque des revendications 6 à 11, qui comprend en outre au moins un autre composé, choisi dans le groupe constitué par les réticulants, les agents de couplage de type silane, les antioxydants, les agents de protection contre le vieillissement, les oxydes métalliques, les hydroxyles métalliques, les pigments blancs.

13. Composition (B) selon la revendication 12, l'autre composé étant un agent de couplage de type silane.

14. Utilisation d'une composition (B) selon l'une quelconque des revendications 6 à 13 pour la préparation d'une feuille destinée à encapsuler un dispositif électronique.
